# EUROPEAN PATENT SPECIFICATION

(11) **EP 4 615 179 B1**
(45) Date of publication and mention of the grant of the patent: **30.09.2026**
(21) Application number: 25159980.9
(22) Date of filing: 25.02.2025
(51) Int. Cl.: H05K 5/30, H05K 7/14

(54) **POWER CABINET**
SCHALTSCHRANK
ARMOIRE ÉLECTRIQUE

(30) Priority: 26.02.2024 CN 202420356505 U
(43) Date of publication of application: 10.09.2025
(73) Proprietor: Sungrow Power Supply Co., Ltd., Hefei, Anhui 230088 (CN)
(72) Inventor: ZHOU, Meng, Hefei, 230088 (CN); JI, Kepeng, Hefei, 230088 (CN)
(74) Representative: DREISS Patentanwälte PartG mbB

(56) References cited:
- WO-A1-2021/057466
- JP-A- H0 983 151
- JP-B2- 3 760 664

## Description

### FIELD

The present disclosure belongs to the technical field of power cabinets, and in particular, to a power cabinet.

### BACKGROUND

Small household power cabinets are arranged in a module stacking manner. During the stacking, due to an electrical connection between modules through a hot-plug, the modules are affected by an external force to generate relative displacement, resulting in arcing or dumping. Therefore, the modules need to be position-limited or fixed. In most existing fixing methods, fixing is necessary for each mounting of the modules, which results in problems such as complex fixing structures of the modules and cumbersome system mounting. JP H0983151A discloses a mounting structure for a communication device. WO 2021/057466A1 discloses a power supply cabinet. JP 3760664B2 discloses a stacking structure of a housing.

### SUMMARY

The present disclosure aims to at least solve one of the technical problems existing in the related art. Therefore, embodiments of the present disclosure provide a power cabinet, which can simplify assembly steps, lower assembly difficulty, reduce use of parts and components, and exert positive effects on assembly, material consumption, processing efficiency, and the like.

The invention is set out in the appended set of claims. In a first aspect, embodiments of the present disclosure provide a power cabinet. The power cabinet includes at least one first module provided with a first assembly portion, at least one second module provided with a second assembly portion, and an assembly member. An end of the assembly member is connected to one of the first assembly portion and the second assembly portion; and another end of the assembly member is configured to be connected to the other one of the first assembly portion and the second assembly portion, or connected to a support structure in a site where the power cabinet is located; or in a case where the power cabinet comprises at least two first module, an end of the assembly member is connected to a first assembly portion of one of the at least two first module; another end of the assembly member is connected to a first assembly portion of another first module; in a case where the power cabinet comprises at least two second module, an end of the assembly member is connected to a second assembly portion of one of the at least two second module; another end of the assembly member is connected to a second assembly portion of another second module.

Each of the at least one first module has a first positioning groove formed on a bottom surface of the first module, and each of the at least one second module has a second positioning protrusion provided on a top surface of the second module and a second positioning groove formed on a bottom surface of the second module, wherein the second positioning protrusion of the second module is configured to be positioned and engaged into a first positioning groove of a first module that is adjacent to and above the second module, or the second positioning protrusion of the second module is configured to be positioned and engaged into a second positioning groove of another second module that is adjacent to and above the second module, wherein one of the at least one first module is an uppermost module of multi-layer modules of the power cabinet.

Alternatively, each of the at least one first module has a first positioning groove formed on a top surface of the first module, and each of the at least one second module has a second positioning groove formed on a top surface of the second module and a second positioning protrusion provided on a bottom surface of the second module, wherein the second positioning protrusion of the second module is configured to be positioned and engaged into the first positioning groove of a first module that is adjacent to and below the second module, or the second positioning protrusion of the second module is configured to be positioned and engaged into the second positioning groove of another second module that is adjacent to and below the second module, wherein one of the at least one first module is a lowermost module of multi-layer modules of the power cabinet.

Alternatively, each of the at least one first module has a first positioning protrusion provided on a top surface of the first module, and each of the at least one second module has a second positioning protrusion provided on a top surface of the second module and a second positioning groove formed on a bottom surface of the second module, wherein the second positioning groove of the second module is configured to be positioned and engaged with the first positioning protrusion of the first module that is adjacent to and below the second module, or the second positioning groove of the second module is configured to be positioned and engaged with the second positioning protrusion of another second module that is adjacent to and below the second module, wherein one of the at least one second module is an uppermost module of multi-layer modules of the power cabinet, and one of the at least one first module is a lowermost module of the multi-layer modules of the power cabinet.

The first assembly portion is mounted at a rear edge of the top surface of the first module; the second assembly portion is mounted at a rear edge of the top surface of the second module; and each of the first assembly portion and the second assembly portion has a rear end extending to a back surface of the power cabinet.

With the power cabinet according to the present disclosure, through the arrangement of the positioning groove, the second positioning protrusion, and the assembly member, position-limitation and fixing of the at least one first module and the at least one second module when vertically stacked are realized, which prevents the first module and the second module from arcing or dumping due to a relative displacement between the first module and the second module when being affected by an external force. Compared with a traditional method in which one fixing is required for each mounting of the modules, the assembly steps are simplified and the assembly difficulty is lowered while shortening mounting man-hours. Moreover, parts and components are reduced. In this way, positive effects are exerted on assembly, material consumption, processing efficiency, and the like.

According to an embodiment of the present disclosure, a projection of the first assembly portion on a horizontal plane is coincident with a projection of the second assembly portion on the horizontal plane.

According to an embodiment of the present disclosure, each of the first assembly portion and the second assembly portion is a recess. The recess is opened outwards at one of side walls of the recess.

According to an embodiment of the present disclosure, each of the at least one first module has a plurality of first positioning grooves, and each of the at least one second module has a plurality of second positioning grooves and a plurality of second positioning protrusions, in which the plurality of first positioning grooves, the plurality of second positioning grooves, and the plurality of second positioning protrusions are in one-to-one correspondence, and the plurality of second positioning protrusions is arranged at intervals on the top surface of each of the at least one second module; or each of the at least one first module has a plurality of first positioning grooves, and each of the at least one second module has a plurality of second positioning grooves and a plurality of second positioning protrusions, in which the plurality of first positioning grooves, the plurality of second positioning grooves, and the plurality of second positioning protrusions are in one-to-one correspondence, and the plurality of second positioning protrusions is arranged at intervals on the bottom surface of each of the at least one second module; or each of the at least one first module has a plurality of first positioning protrusions, and each of the at least one second module includes a plurality of second positioning grooves and a plurality of second positioning protrusions, in which the plurality of first positioning protrusions, the plurality of second positioning grooves, and the plurality of second positioning protrusions are in one-to-one correspondence, and the plurality of second positioning protrusions is arranged at intervals on the top surface of each of the at least one second module.

According to an embodiment of the present disclosure, the plurality of protrusions is arranged at intervals on respective edges of the top surface of each of the at least one second module; and/or the plurality of second positioning protrusions is arranged at intervals on respective edges of the bottom surface of each of the at least one second module; and/or the plurality of first positioning protrusions is arranged at intervals on respective edges of the bottom surface of each of the at least one first module.

According to an embodiment of the present disclosure, two ends of the assembly member are connected to the first modules or the second modules, in which the assembly member includes a body segment and a bent segment connected to two ends of the body segment and bent. The bent segment is connected to the first assembly portion or the second assembly portion.

According to an embodiment of the present disclosure, one first module and a plurality of second modules are provided. The one first module and the plurality of second modules are stacked in the vertical direction. The one first module is located above an uppermost second module of the plurality of second modules.

According to an embodiment of the present disclosure, two first module and at least one second module are provided. The two first modules and the at least one second module are stacked in the vertical direction. An uppermost first module of the two first modules is located above an uppermost second module of the at least one second module, and the at least one second module is arranged between the two first modules.

Additional aspects and advantages of the present disclosure will be given in part in the following description, or become apparent in part from the following description, or can be learned from practicing of the present disclosure.

### BRIEF DESCRIPTION OF THE DRAWINGS

The above and/or additional aspects and advantages of the present disclosure will become more apparent and more understandable from the following description of embodiments taken in conjunction with the accompanying drawings, in which:
FIG. 1 is an exploded structural view of a power cabinet according to an embodiment of the present disclosure.
FIG. 2 is a schematic structural view of a power cabinet according to an embodiment of the present disclosure.
FIG. 3 is a first cross-sectional view of a power cabinet according to an embodiment of the present disclosure.
FIG. 4 is a second cross-sectional view of a power cabinet according to an embodiment of the present disclosure.
FIG. 5 is a schematic structural view of a first module according to an embodiment of the present disclosure.
FIG. 6 is a cross-sectional view of a first module according to an embodiment of the present disclosure.
FIG. 7 is a schematic structural view of a second module according to an embodiment of the present disclosure.
FIG. 8 is a cross-sectional view of a second module according to an embodiment of the present disclosure.
FIG. 9 is a third cross-sectional view of a power cabinet according to an embodiment of the present disclosure.
FIG. 10 is a first exploded view of a partial structure of a power cabinet according to an embodiment of the present disclosure.
FIG. 11 is a fourth cross-sectional view of a power cabinet according to an embodiment of the present disclosure.
FIG. 12 is a second exploded view of a partial structure of a power cabinet according to an embodiment of the present disclosure.

### Reference numerals:

power cabinet 100;
first module 110, first assembly portion 111, first positioning groove 112, first positioning protrusion 113;
second module 120, second assembly portion 121, second positioning groove 122, second positioning protrusion 123;
assembly member 130, body segment 131, bent segment 132.

### DETAILED DESCRIPTION

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limiting, the present disclosure.

Embodiments of the present disclosure disclose a power cabinet 100. The power cabinet 100 may be a household power cabinet.

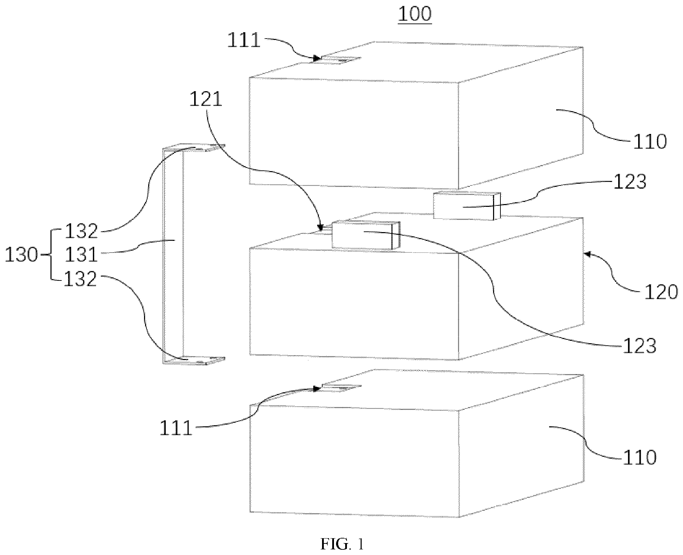

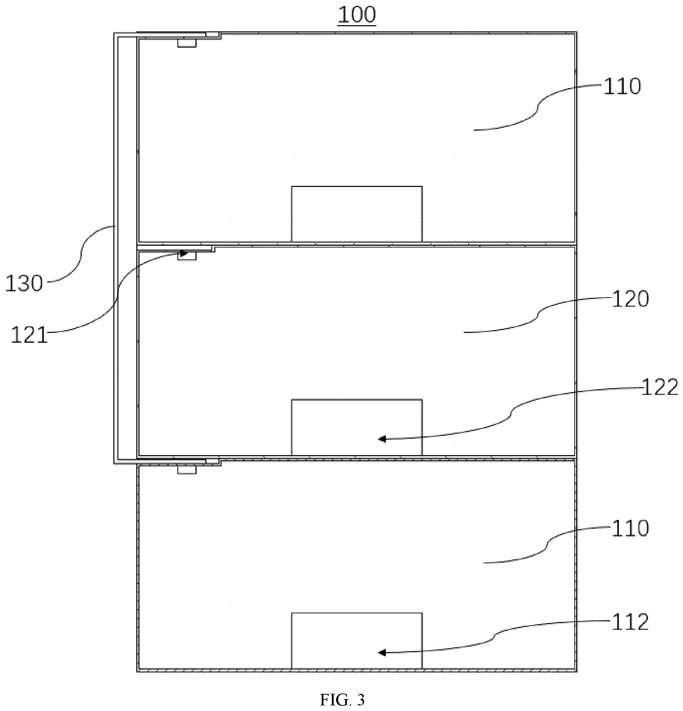

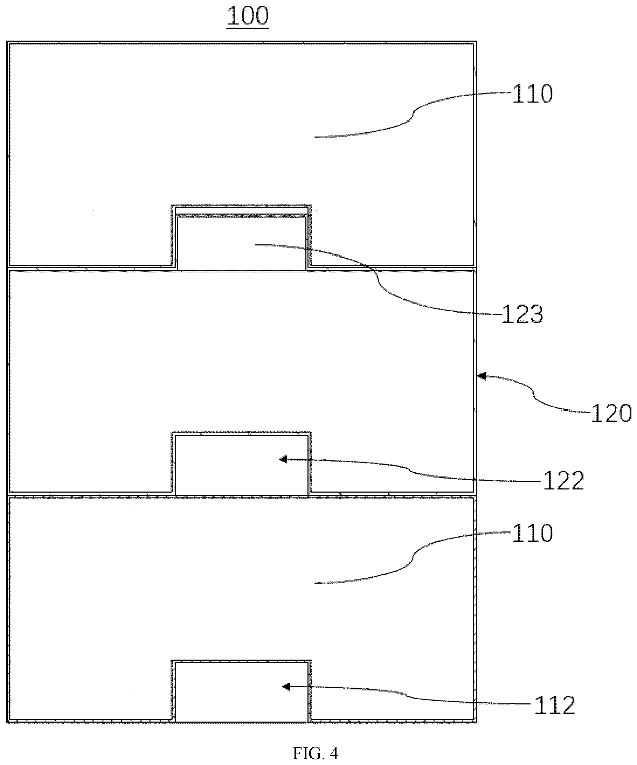

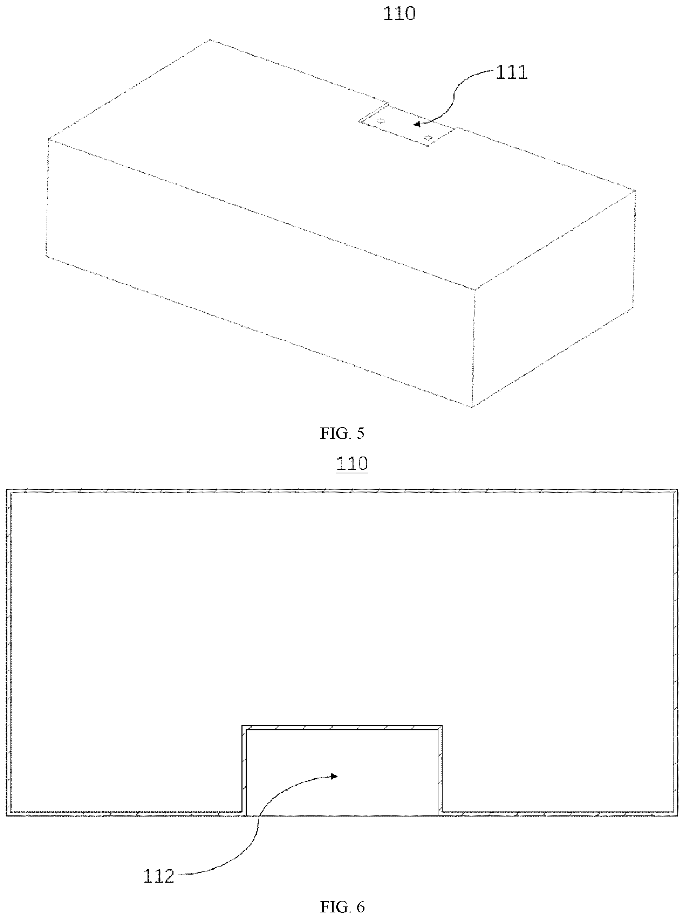

The power cabinet 100 according to the embodiments of the present disclosure will be described below with reference to FIG. 1 to FIG. 12.

In some embodiments, as shown in FIG. 1 to FIG. 3, the power cabinet 100 includes an assembly member 130, at least one first module 110, and at least one second module 120.

The first module 110 is provided with a first assembly portion 111. The second module 120 is provided with a second assembly portion 121. The at least one first module 110 and the at least one second module 120 are stacked and arranged in a vertical direction. The assembly member 130 has an end connected to the first assembly portion 111 or the second assembly portion 121 and another end configured to be connected to one of the first assembly portion 111, the second assembly portion 121, or a support structure in a site where the power cabinet 100 is located. Each of the at least one first module 110 has a first positioning groove 112 formed on a bottom surface of the first module 110, and each of the at least one second module 120 has a second positioning protrusion 123 provided on a top surface of the second module 120 and a second positioning groove 122 formed on a bottom surface of the second module 120, in which one of the at least one first module 110 is an uppermost module of multi-layer modules of the power cabinet 100. In an exemplary embodiment, each of the at least one first module 110 has a first positioning groove 112 formed on a bottom surface of the first module 110, and each of the at least one second module 120 has a second positioning groove 122 formed on a top surface of the second module 120 and a second positioning protrusion 123 provided on a bottom surface of the second module 120., in which one of the at least one first module 110 is a lowermost module of multi-layer modules of the power cabinet 100. In another exemplary embodiment, each of the at least one first module 110 has a first positioning protrusion 113 provided on a top surface of the first module 110, and each of the at least one second module 120 has a second positioning protrusion 123 provided on a top surface of the second module 120 and a second positioning groove 122 formed on a bottom surface of the second module 120, in which one of the at least one second module 120 is an uppermost module of multi-layer modules of the power cabinet 100, and one of the at least one first module 110 is a lowermost module of the multi-layer modules of the power cabinet 100.

The at least one first module 110 and the at least one second module 120 may be stacked. In other words, there may be one or more first modules 110 and one or more second modules 120.

For example, in some embodiments, as shown in FIG. 1 to FIG. 4, there may be two first modules 110 and one second module 120.

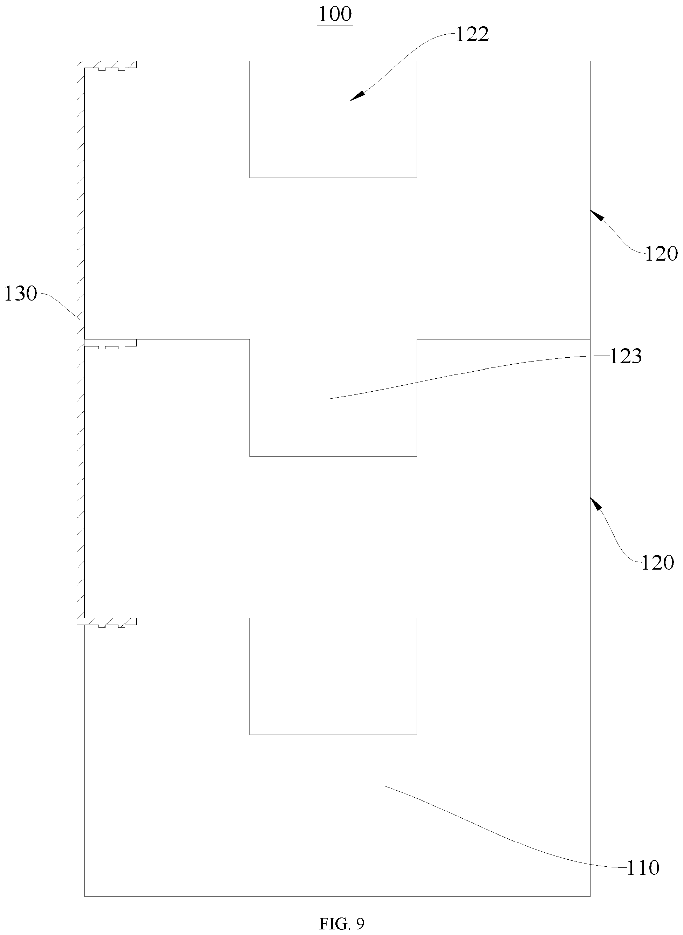

For example, in some other embodiments, as shown in FIG. 9 to FIG. 12, there may be one first module 110 and two second modules 120.

For example, in yet other embodiments, there may be one first module 110 and ten second modules 120.

The support structure in the site where the power cabinet 100 is located may be any fixed building structure or a stably and reliably inherent environment structure in the site where the power cabinet 100 is located, such as floor, wall, and post, which is not limited herein.

As shown in FIG. 1 to FIG. 4, the first module 110 is a structure recessed having a lower surface with a recess, and the second module 120 is a structure having an upper surface with a protrusion and a lower surface with a recess. The second positioning protrusion 123 of the second module 120 may be positioned and engaged into the first positioning groove 112 of the first module 110, or the second positioning protrusion 123 of the second module 120 may be positioned and engaged into a second positioning groove 122 of another second module 120 adjacent to the second module 120.

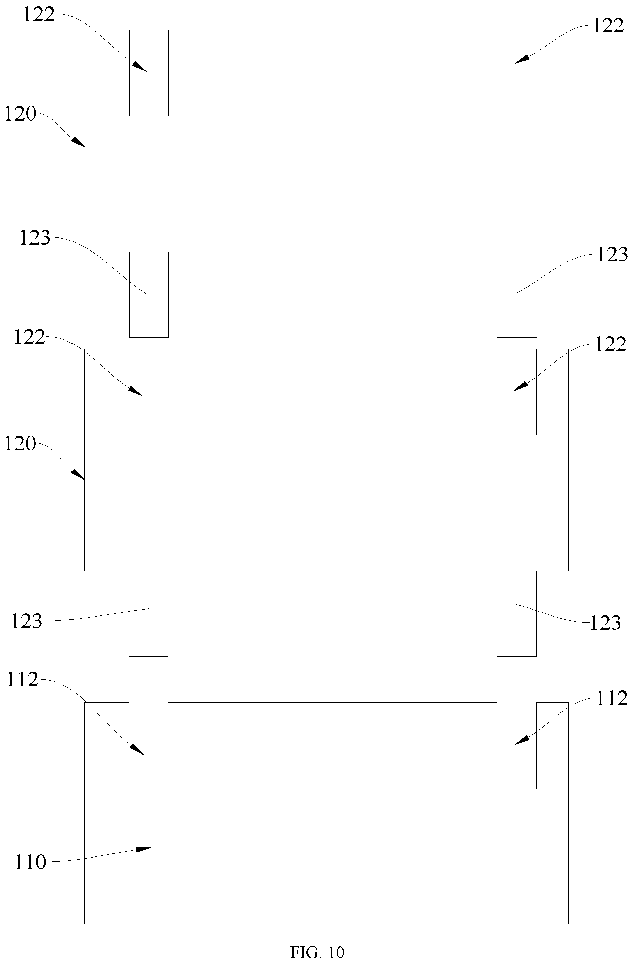

In an exemplary embodiment, as shown in FIG. 9 and FIG. 10, the first module 110 is a structure having an upper surface with a recess, and the second module 120 is a structure having an upper surface with a recess and a lower surface with a protrusion. The second positioning protrusion 123 of the second module 120 may be positioned and engaged into the first positioning groove 112 of the first module 110, or the second positioning protrusion 123 of the second module 120 may be positioned and engaged into the second positioning groove 122 of another second module 120 adjacent to the second module 120.

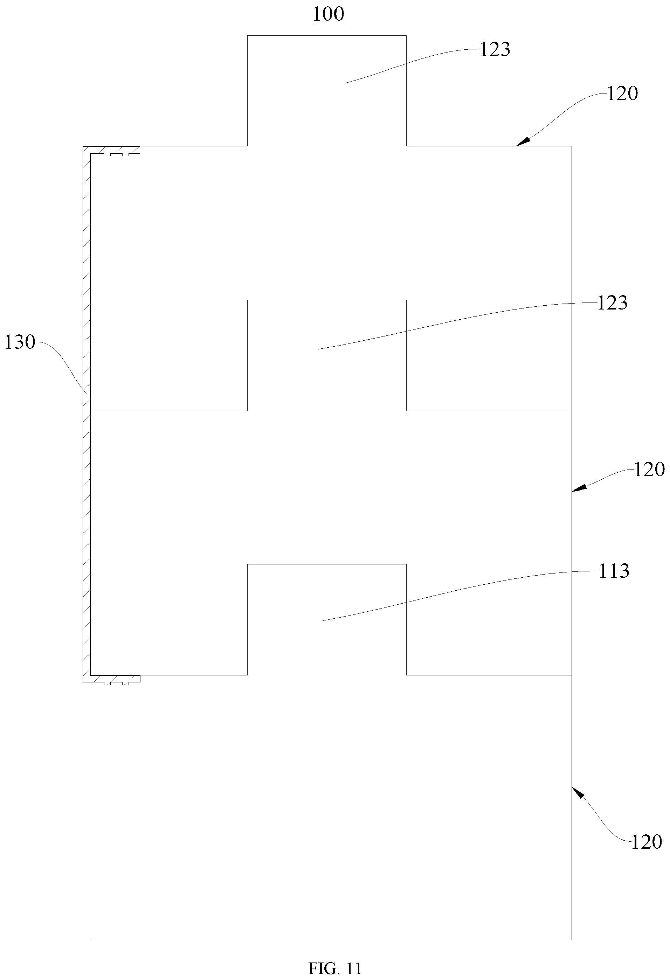

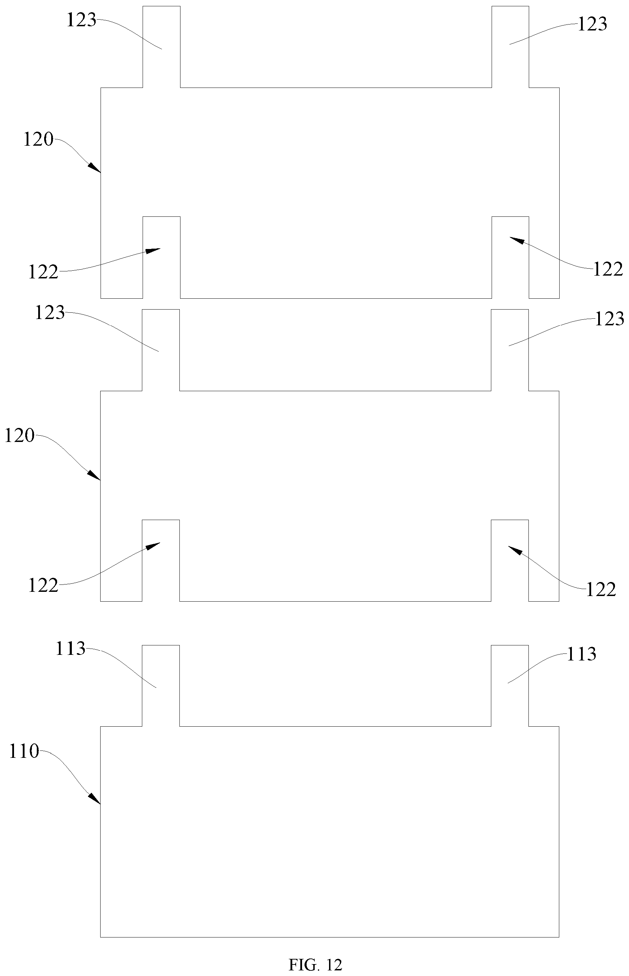

In another exemplary embodiment, as shown in FIG. 11 and FIG. 12, the first module 110 is a structure having an upper surface with a recess, and the second module 120 is a structure having an upper surface with a protrusion and a lower surface with a recess. The second positioning groove 122 of the second module 120 may be positioned and engaged with the first positioning protrusion 113 of the first module 110, or the second positioning groove 122 of the second module 120 may be positioned and engaged with the second positioning protrusion 123 of another second module 120 adjacent to the second module 120.

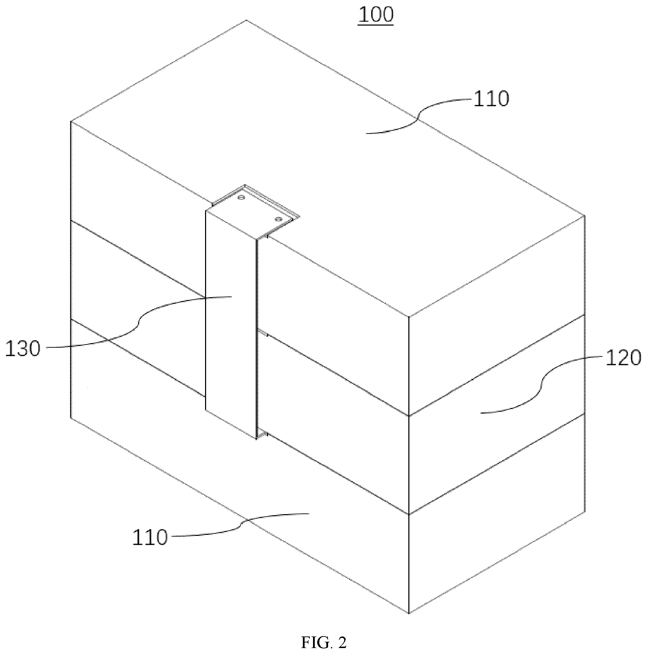

A connection between the assembly member 130 and the first assembly portion 111 may include, but is not limited to, a bolt connection, welding, an interference fit, and the like, which is not limited herein. For example, in some embodiments, as shown in FIG. 1 and FIG. 2, the connection between the assembly member 130 and the first assembly portion 111 is implemented through the bolt connection.

A connection between the assembly member 130 and the second assembly portion 121 may include, but is not limited to, a bolt connection, welding, an interference fit, and the like, which is not limited herein. For example, in some embodiments, the connection between the assembly member 130 and the second assembly portion 121 is implemented through the bolt connection.

An assembly of the assembly member 130 may be implemented by at least one of the following five solutions.

For a first solution, as shown in FIG. 1 to FIG. 4, the assembly member 130 has an end connected to the first assembly portion 111 of the first module 110 and another end connected to a first assembly portion 111 of another first module 110.

For a second solution, as shown in FIG. 9 to FIG. 12, the assembly member 130 has an end connected to the first assembly portion 111 and another end connected to the second assembly portion 121.

For a third solution, the assembly member 130 has an end connected to the second assembly portion 121 of the second module 120 and another end connected to a second assembly portion 121 of another second module 120.

For a fourth solution, the assembly member 130 has an end connected to the first assembly portion 111 and another end connected to the support structure in the site where the power cabinet 100 is located.

For a fifth solution, the assembly member 130 has an end connected to the second assembly portion 121 and another end connected to the support structure in the site where the power cabinet 100 is located.

During actual implementation, in an example, as shown in FIG. 1 to FIG. 4, two first modules 110 and one second module 120 are stacked together, i.e., one first module 110, one second module 120, and one first module 110 are stacked sequentially in a top-to-bottom direction. One end of the assembly member 130 may be connected to the first assembly portion 111 of one of the two first modules 110, and the other end of the assembly member 130 may be connected to the first assembly portion 111 of the other first module 110. The second module 120 may be sandwiched between the two first modules 110. The second positioning protrusion 123 of the second module 120 may be positioned and engaged into the first positioning groove 112 of the uppermost first module 110 of the two first modules 110. In an exemplary embodiment, more modules may be provided by arranging a plurality of second modules 120 between the two first modules 110 or by arranging a plurality of second modules 120 below the lowermost first module 110 of the two first modules 110. A plurality of assembly members 130 may be arranged at intervals while providing more modules. In some embodiments, one assembly member 130 may be provided for every three modules.

In another example, as shown in FIG. 9 and FIG. 10, one first module 110 and two second modules 120 are stacked together, i.e., one second module 120, one second module 120, and one first module 110 are stacked sequentially in a top-to-bottom direction. One end of the assembly member 130 may be connected to the first assembly portion 111 of the first module 110, and the other end of the assembly member 130 may be connected to the second assembly portion 121 of one of the two second modules 120. The one first module 110 may be a lowest module of the power cabinet 100, and the second positioning protrusion 123 of the other one of the two second modules 120 may be positioned and engaged into the first positioning groove 112 of the lowermost first module 110. More modules may be provided by arranging a plurality of first modules 110 and/or a plurality of second modules 120 above the lowermost first module 110.

In a yet another example, as shown in FIG. 11 and FIG. 12, one first module 110 and two second modules 120 are stacked together, i.e., one second module 120, one second module 120, and one first module 110 are stacked sequentially in a top-to-bottom direction. One end of the assembly member 130 may be connected to the first assembly portion 111 of the first module 110, and the other end of the assembly member 130 may be connected to the second assembly portion 121 of one of the two second modules 120. The one of the two second modules 120 may be an uppermost module of the power cabinet 100, and the first module 110 may be a lowermost module of the power cabinet 100. The second positioning protrusion 123 of the uppermost second module 120 may be positioned and engaged into the second positioning groove 122 of a further second module 120. The first positioning protrusion 113 of the lowermost first module 110 may be positioned and engaged into the second positioning groove 122 of the other one of the two second modules 120. More modules may be provided by arranging a plurality of second modules 120 above the lowermost first module 110.

In the power cabinet 100 according to the embodiments of the present disclosure, through the arrangement of the positioning groove, the second positioning protrusion 123, and the assembly member 130, position-limitation and fixing of the at least one first module 110 and the at least one second module 120 when being vertically stacked are realized, which can prevent the first module 110 and the second module 120 from arcing or dumping due to the relative displacement between the first module 110 and the second module 120 when being affected by an external force. Compared with the traditional method in which one fixing is required for each mounting of the modules, the assembly steps are simplified and the assembly difficulty is lowered while shortening mounting man-hours. Moreover, parts and components are reduced. In this way, positive effects are exerted on assembly, material consumption, processing efficiency, and the like.

In some embodiments, as shown in FIG. 1 to FIG. 3, FIG. 5, FIG. 7 to FIG. 9, and FIG. 11, the first assembly portion 111 may be mounted on the top surface of the first module 110, and the second assembly portion 121 may be mounted on the top surface of the second module 120.

In this implementation, as shown in FIG. 1 to FIG. 3, FIG. 5, FIG. 7 to FIG. 9, and FIG. 11, the first assembly portion 111 may be located at an edge of the top surface of the first module 110, and may be located at a middle of the edge. The second assembly portion 121 may be located at an edge of the top surface of the second module 120, and may be located at a middle of the edge.

In another implementation, the first assembly portion 111 may be mounted on the bottom surface of the first module 110, and the second assembly portion 121 may be mounted on the bottom surface of the second module 120.

In a yet another implementation, the first assembly portion 111 may be mounted on a side surface of the first module 110, and the second assembly portion 121 may be mounted on a side surface of the second module 120.

In the power cabinet 100 according to the embodiments of the present disclosure, assembly positions of the second module 120 and the second module 120 are concentrated on the top surface through the design of the arrangement position of the assembly portion as described above. Compared with the bottom surface and the side surface, a stress strength between the assembly member 130 and the first module 110 and a stress strength between the assembly member 130 and the second module 120 are enhanced. Meanwhile, the assembly member 130 is prevented from causing serious corrosion due to direct contact with ground dirt. Therefore, a service life of the entire power cabinet 100 can be prolonged.

In some embodiments, as shown in FIG. 1 to FIG. 3, FIG. 9, and FIG. 11, each of the first assembly portion 111 and the second assembly portion 121 has a rear end extending to a back surface of the power cabinet 100.

In this implementation, as shown in FIG. 1 to FIG. 3, FIG. 9, and FIG. 11, the assembly member 130 may be attached to the back surface of the power cabinet 100. A front surface of the power cabinet 100 may be user-oriented, and the back surface of the power cabinet 100 may face towards a wall. The assembly member 130 may be connected to the first assembly portion 111 and the second assembly portion 121 in a rear-to-front direction. The assembly member 130 may be hidden between the wall and the stacked modules after the power cabinet 100 is mounted on the ground.

In the power cabinet 100 according to the embodiments of the present disclosure, through the design of the arrangement of the assembly member 130, the assembly member 130 may be hidden between the wall and the stacked modules after the product is deployed, to prevent the assembly member 130 from being exposed, which would cause the assembly member 130 to be easily impacted by external objects during a service cycle. Therefore, a probability of damage or even failure of the assembly members 130 due to external disturbances can be lowered.

In some embodiments, as shown in FIG. 1 to FIG. 3, FIG. 9, and FIG. 11, a projection of the first assembly portion 111 on a horizontal plane is coincident with a projection of the second assembly portion 121 on the horizontal plane.

In this implementation, as shown in FIG. 1 to FIG. 3, one end of the assembly member 130 is connected to the first assembly portion 111 of one of the two first modules 110, and the other end of the assembly member 130 is connected to the first assembly portion 111 of the other first module 110. The second module 120 may be sandwiched between the two first modules 110. The second positioning protrusion 123 of the second module 120 may be positioned and engaged into the first positioning groove 112 of the uppermost first module 110. After the assembly member 130 is mounted, based on a structural design where the projection of the first assembly portion 111 on the horizontal plane is coincident with the projection of the second assembly portion 121 on the horizontal plane, the assembly member 130 may shield the second assembly portion 121 of the second module 120 located between the two first modules 110.

In another implementation, the projection of the first assembly portion 111 on the horizontal plane may be partially coincident with the projection of the second assembly portion 121 on the horizontal plane.

In yet another implementation, the projection of the first assembly portion 111 on the horizontal plane may be completely in-coincident with the projection of the second assembly portion 121 on the horizontal plane.

In the power cabinet 100 according to the embodiments of the present disclosure, through a spatial position design of the first assembly portion 111 and the second assembly portion 121 as described above, the first assembly portion 111 and the second assembly portion 121 are located at a same position in the horizontal direction, and the assembly member 130 in a vertical state may be connected to both the first assembly portion 111 and the second assembly portion 121, which saves a material cost of the assembly member 130 while facilitating processing.

In some embodiments, as shown in FIG. 1 to FIG. 3, FIG. 5, FIG. 7 to FIG. 9, and FIG. 11, each of the first assembly portion 111 and the second assembly portion 121 is a recess. The recess is opened outwards at one of side walls of the recess.

In this implementation, as shown in FIG. 1 to FIG. 3, FIG. 5, FIG. 7 to FIG. 9, and FIG. 11, a rear end of the recess may extend to the back surface of the power cabinet 100 and be opened. The recess may be provided with a threaded hole at a bottom wall of the recess. The assembly member 130 may be provided with a corresponding connection hole. When the assembly member 130 is engaged with the first assembly portion 111 or the second assembly portion 121, the assembly member 130 may be pushed forwards into the recess from the back surface of the power cabinet 100, and a threaded connector may pass through the connection hole and the threaded hole and then be tightened for fixing.

In another implementation, each of the first assembly portion 111 and the second assembly portion 121 may be a snap.

In a yet another implementation, each of the first assembly portion 111 and the second assembly portion 121 may be a protrusion.

In the power cabinet 100 according to the embodiments of the present disclosure, through the structural design where each of the first assembly portion 111 and the second assembly portion 121 is a recess, after the assembly member 130 is connected to the modules, the adjacent modules may be in a tightly attached state, to prevent an upper-layer module from upwarping, thereby improving structure reliability of the entire power cabinet 100.

In some embodiments, as shown in FIG. 1, FIG. 7, FIG. 10, and FIG. 12, each of the at least one first module 110 may have a plurality of first positioning grooves 112, and each of the at least one second module 120 may have a plurality of second positioning grooves 122 and a plurality of second positioning protrusions 123, in which the plurality of first positioning grooves 112, the plurality of second positioning grooves 122, and the plurality of second positioning protrusions 123 may be in one-to-one correspondence, and the plurality of second positioning protrusions 123 may be arranged at intervals on the top surface of each of the at least one second module 120; or each of the at least one first module 110 may have a plurality of first positioning grooves 112, and each of the at least one second module 120 may have a plurality of second positioning grooves 122 and a plurality of second positioning protrusions 123, in which the plurality of first positioning grooves 112, the plurality of second positioning grooves 122, and the plurality of second positioning protrusions 123 may be in one-to-one correspondence, and the plurality of second positioning protrusions 123 may be arranged at intervals on the bottom surface of each of the at least one second module 120; or each of the at least one first module 110 may have a plurality of first positioning protrusions 113, and each of the at least one second module 120 may have a plurality of second positioning grooves 122 and a plurality of second positioning protrusions 123, in which the plurality of first positioning protrusions 113, the plurality of second positioning grooves 122, and the plurality of second positioning protrusions 123 may be in one-to-one correspondence, and the plurality of second positioning protrusions 123 may be arranged at intervals on the top surface of each of the at least one second module 120.

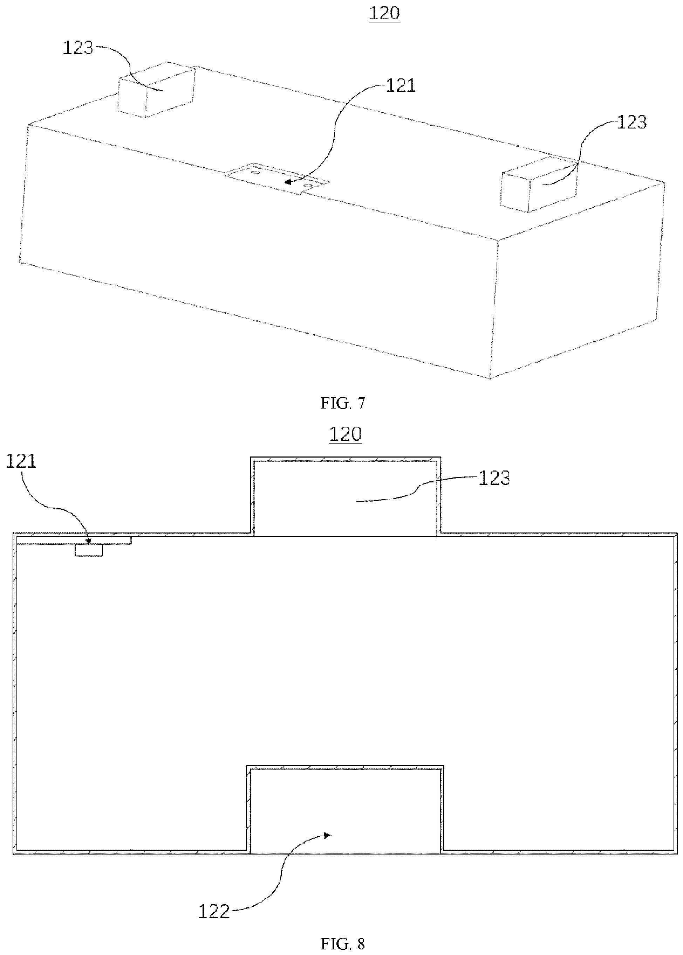

For example, the term "plurality of" means two or more. For example, in some embodiments, as shown in FIG. 1 and FIG. 7, each first module 110 may include two first positioning grooves 112, and each second module 120 may include two second positioning grooves 122 and two second positioning protrusions 123. In this case, the two first positioning grooves 112, the two second positioning grooves 122, and the two second positioning protrusions 123 may be in one-to-one correspondence, and the two second positioning protrusions 123 may be spaced apart from each other on the top surface of each second module 120.

In this implementation, as shown in FIG. 1, FIG. 7, FIG. 10, and FIG. 12, the two second positioning protrusions may be opposite to each other.

In another implementation, the two second positioning protrusions may also be offset from each other.

In the power cabinet 100 according to the embodiments of the present disclosure, through the design where each second module 120 includes the plurality of second positioning grooves 122 and the plurality of second positioning protrusions 123 as described above, it is further realized that the positions of the at least one first module 110 and the at least one second module 120 are limited when the at least one first module 110 and the at least one second module 120 are stacked in the vertical direction, which can prevent the first module 110 and the second module 120 from arcing or dumping due to the relative displacement between the first module 110 and the second module 120 when being affected by the external force as much as possible. Meanwhile, positioning accuracy can be improved during the stacking.

In some embodiments, as shown in FIG. 1, FIG. 7, FIG. 10, and FIG. 12, the plurality of second positioning protrusions 123 may be arranged at intervals on respective edges of the top surface of the second module 120; and/or the plurality of second positioning protrusions 123 may be arranged at intervals on respective edges of the bottom surface of the second module 120; and/or the plurality of first positioning protrusions 113 may be arranged at intervals on respective edges of the bottom surface of the first module 110.

In this implementation, exemplarily, as shown in FIG. 1 and FIG. 7, the two second positioning protrusions 123 may be spaced apart from each other on the top surface of the second module 120, and may be located on two different edges of the top surface of the second module 120. Further, the two second positioning protrusions 123 may be arranged separately from the second assembly portion 121, and the two second positioning protrusions 123 and the second assembly portion 121 may be located on three different edges of the top surface of the second module 120.

In an example, as shown in FIG. 10, the two second positioning protrusions 123 may be spaced apart from each other on the bottom surface of each second module 120, and may be located on two different edges of the bottom surface of each second module 120.

In another example, as shown in FIG. 12, the two first positioning protrusions 113 are spaced apart from each other on the top surface of the first module 110, and may be located on two different edges of the top surface of the first module 110. Further, the two first positioning protrusions 113 may be arranged separately from the first assembly portion 111, and the two first positioning protrusions 113 and the first assembly portion 111 may be located on three different edges of the top surface of the second module 120. The second positioning protrusions 123 may be spaced apart from each other on the top surface of each second module 120, and may be located on two different edges of the top surface of each second module 120. Further, the second positioning protrusions 123 may be arranged separately from the second assembly portion 121, and the two second positioning protrusions 123 and the second assembly portion 121 may be located on three different edges of the top surface of each second module 120.

In another implementation, three protrusions may be arranged at intervals on three edges of the top surface of the second module 120.

In a yet another implementation, four protrusions may be arranged at intervals on four edges of the top surface of the second module 120.

In the power cabinet 100 according to the embodiments of the present disclosure, through a structural design where the plurality of protrusions are arranged at intervals on the respective edge of the top surface of the second module 120, it is realized that position-limit and mounting of different edges of the top surface of each second module 120 are performed by the plurality of protrusions. Therefore, an offset between different modules when the stacking the modules can be reduced while improving a structural strength of the entire power cabinet 100.

In some embodiments, as shown in FIG. 1 to FIG. 3, FIG. 9, and FIG. 11, in a case where two ends of the assembly member 130 are connected to the first modules 110 or the second modules 120, the assembly member 130 may include a body segment 131 and a bent segment 132 connected to two ends of the body segment 131 and bent. The bent segment 132 may be connected to the first assembly portion 111 or the second assembly portion 121.

The assembly member 130 may be a sheet metal part. In an example, the assembly member 130 may be made of a material including, but not limited to, aluminum alloy, stainless steel, titanium alloy, or the like, which is not limited herein. For example, in some embodiments, the assembly member 130 may be made of stainless steel.

In this implementation, as shown in FIG. 1 to FIG. 3, FIG. 9, and FIG. 11, two bent segments 132 connected to two ends of the body segment 131 may have the same bending directions. The body segment 131 may be attached to the back surface of the power cabinet 100. Each of the first assembly portion 111 and the second assembly portion 121 may be a recess. When the assembly member 130 is engaged with the first assembly portion 111 or the second assembly portion 121, the bent segment 132 may be mounted in the recess, and the threaded connector may pass through the connection hole on the bent segment 132 and the threaded hole on the bottom wall of the recess and then be tightened for fixing.

In the power cabinet 100 according to the embodiments of the present disclosure, a connection between two modules or a connection between a single module and the support structure in the site where the power cabinet 100 is located is realized through the arrangement of the body segment 131 and the bent segment 132 as described above. As a result, an overall structure is simple and functional partition is clear. Therefore, a miniaturization and lightweight design is realized, which is conducive to mass production.

In some embodiments, the at least one first module 110 includes one first module 110. The at least one second module 120 may include a plurality of second modules 120. The one first module 110 and the plurality of second modules 120 may be stacked in the vertical direction. The one first module 110 may be located above an uppermost second module 120 of the plurality of second modules 120.

In this implementation, two ends of the assembly member 130 may be respectively connected to one first module 110 and one second module 120. At least one second module 120 may be sandwiched between the one first module 110 and the one second module 120. Further, the one first module 110 severs as the uppermost module, and the second positioning protrusion 123 of the uppermost second module 120 of the at least one second module 120 may be positioned and engaged with the first positioning groove 112 of the uppermost first module 110. In this case, more second modules 120 may be provided by arranging a plurality of second modules 120 between the first module 110 and the second module 120 that are connected by the assembly member 130; or more second modules 120 may be provided by arranging a plurality of second modules 120 below the second module 120 to which the assembly member 130 is connected.

In the power cabinet 100 according to the embodiments of the present disclosure, through the design of the stacking manner of one first module 110 and the plurality of second modules 120 as described above, the assembly member 130 may be connected to the first module 110 and the second module 120 simultaneously, and the number of the modules may be adjusted in different manner as desired, thereby increasing flexibility and practicability of the power cabinet 100. Meanwhile, the overall structure is simplified, mounting and fixed connection parts of the modules are reduced, and mounting steps are reduced while ensuring a reliable connection.

In some embodiments, as shown in FIG. 1 to FIG. 4, two first modules 110 and at least one second module 120 may be provided. The two first modules 110 and the at least one second module 120 may be stacked in the vertical direction. In this case, an uppermost first module 110 of the two first modules 110 may be located above an uppermost second module 120 of the at least one second modules 120, and the at least one second module 120 may be provided between the two first modules 110.

The embodiments of the present disclosure will be described in detail below from two different implementations.

In a first implementation, two ends of the assembly member 130 are connected to two first modules 110, respectively.

In this implementation, as shown in FIG. 1 to FIG. 4, the one end of the assembly member 130 may be connected to the first assembly portion 111 of one of the two first modules 110, and the other end of the assembly member 130 may be connected to the first assembly portion 111 of the other first module 110. The at least one second module 120 may be sandwiched between the two first modules 110. The second positioning protrusion 123 of the uppermost second module 120 may be positioned and engaged into the first positioning groove 112 of the uppermost first module 110 of the two first modules 110. In this case, more second modules 120 may be provided by arranging a plurality of second modules 120 between the two first modules 110 or by arranging a plurality of second modules 120 below the lowermost first module 110 of the two first modules 110.

In a second implementation, two ends of the assembly member 130 are respectively connected to one first module 110 and one second module 120.

In this implementation, the one end of the assembly member 130 may be connected to the first assembly portion 111 of the first module 110, and the other end of the assembly member 130 may be connected to the second assembly portion 121 of the second module 120. Moreover, the first module 110 severs as the uppermost module, and one first module 110 may be sandwiched between the first module 110 and the second module 120. In this case, more second modules 120 may be provided by arranging a plurality of second modules 120 between the first module 110 and the second module 120 that are connected by the assembly member 130, or by arranging a plurality of second modules 120 below the second modules 120 to which the assembly member 130 is connected.

In the power cabinet 100 according to the embodiments of the present disclosure, through the design of the stacking manner of the one first module 110 and the plurality of second modules 120, it is possible to select different arrangement to arrange the assembly member 130 and adjust the number of the modules as desired. Therefore, flexibility and diversity of the assembly manner of the power cabinet 100 is maximized while shortening the mounting man-hours. In addition, the use of spare and parts and components are reduced. In this way, positive effects are exerted on assembly, material consumption, processing efficiency, and the like.

Terms such as "first" and "second" in the embodiments and claims of the present disclosure are used only to distinguish between similar objects, rather than to describe a particular order or sequence. It should be understood that the data as used can be interchanged where appropriate, to enable the embodiments of the present disclosure described herein to be implemented in an order other than that illustrated or described herein. Also, the objects distinguished by the terms such as "first" and "second" are usually objects of the same type. The quantity of objects is not limited. For example, a first object may be one first object or plurality of first objects. In addition, "and/or" throughout the specification and claims indicates at least one of the objects associated with "and/or". The character "/" generally indicates that the associated objects before and after the character are in an "or" relationship.

In the description of the present disclosure, it needs to be understood that, orientation or position relationship indicated by terms such as "over", "below", "front", "back", "vertical", "horizontal", "top", "bottom", "in", and "out" is based on the orientation or position relationship shown in the accompanying drawings, and is merely for the convenience of describing the present disclosure and simplifying the description, rather than indicating or implying that the associated device or element must have a specific orientation, or be constructed and operated in a specific orientation, and therefore cannot be understood as a limitation on the present disclosure.

In the description of the present disclosure, "the first feature" and "the second feature" may include at least one of the features.

In the description of the present disclosure, "plurality" means at least two.

In the description of the present disclosure, the first feature being "on" or "under" the second feature may include the scenarios that the first feature is in direct contact with the second feature, or the first and second features, instead of being in direct contact with each other, are in contact with each other through another feature therebetween.

In the description of the present disclosure, the first feature being "above" the second feature may indicate that the first feature is directly above or obliquely above the second feature, or simply indicate that the level of the first feature is higher than that of the second feature.

In the description of this specification, descriptions with reference to the terms "an embodiment", "some embodiments", "illustrative embodiments", "examples", "specific examples", or "some examples", etc. mean that specific features, structure, materials, or characteristics described in conjunction with the embodiment or example are included in at least one embodiment or example of the present disclosure. In this specification, the schematic representations of the above terms do not necessarily refer to the same implementation or example. Moreover, the described specific features, structures, materials or characteristics may be combined in any one or more embodiments or examples in a suitable manner.

Although the embodiments of the present disclosure have been shown and described above, it can be understood by those of ordinary skill in the art that various changes, modifications, replacements, and variations may be made to these embodiments without departing from the principles of the present disclosure. The scope of the present disclosure is defined by the claims as appended.

## Claims

1. A power cabinet (100), comprising:
at least one first module (110) provided with a first assembly portion (111);
at least one second module (120) provided with a second assembly portion (121), the at least one first module (110) and the at least one second module (120) being stacked in a vertical direction; and
an assembly member (130),
wherein an end of the assembly member (130) is connected to one of the first assembly portion (111) and the second assembly portion (121); and another end of the assembly member (130) is configured to be connected to the other one of the first assembly portion (111) and the second assembly portion (121), or connected to a support structure in a site where the power cabinet (100) is located; or
in a case where the power cabinet (100) comprises at least two first modules, an end of the assembly member (130) is connected to a first assembly portion (111) of one of the at least two first modules; another end of the assembly member (130) is connected to a first assembly portion (111) of another first module; or
in a case where the power cabinet (100) comprises at least two second modules, an end of the assembly member (130) is connected to a second assembly portion (121) of one of the at least two second modules; another end of the assembly member (130) is connected to a second assembly portion (121) of another second module;
wherein:
each of the at least one first module (110) has a first positioning groove (112) formed on a bottom surface of the first module (110), and each of the at least one second module (120) has a second positioning protrusion (123) provided on a top surface of the second module (120) and a second positioning groove (122) formed on a bottom surface of the second module (120), wherein the second positioning protrusion (123) of the second module (120) is configured to be positioned and engaged into a first positioning groove (112) of a first module (110) that is adjacent to and above the second module (120), or the second positioning protrusion (123) of the second module (120) is configured to be positioned and engaged into a second positioning groove (122) of another second module (120) that is adjacent to and above the second module (120), wherein one of the at least one first module (110) is an uppermost module of multi-layer modules of the power cabinet (100); or
each of the at least one first module (110) has a first positioning groove (112) formed on a top surface of the first module (110), and each of the at least one second module (120) has a second positioning groove (122) formed on a top surface of the second module (120) and a second positioning protrusion (123) provided on a bottom surface of the second module (120), wherein the second positioning protrusion (123) of the second module (120) is configured to be positioned and engaged into the first positioning groove (112) of a first module (110) that is adjacent to and below the second module (120), or the second positioning protrusion (123) of the second module (120) is configured to be positioned and engaged into the second positioning groove (122) of another second module (120) that is adjacent to and below the second module (120), wherein one of the at least one first module (110) is a lowermost module of multi-layer modules of the power cabinet (100); or
each of the at least one first module (110) has a first positioning protrusion (113) provided on a top surface of the first module (110), and each of the at least one second module (120) has a second positioning protrusion (123) provided on a top surface of the second module (120) and a second positioning groove (122) formed on a bottom surface of the second module (120), wherein the second positioning groove (122) of the second module (120) is configured to be positioned and engaged with the first positioning protrusion (113) of a first module (110) that is adjacent to and below the second module (120), or the second positioning groove (122) of the second module (120) is configured to be positioned and engaged with the second positioning protrusion (123) of another second module (120) that is adjacent to and below the second module (120), wherein one of the at least one second module (120) is an uppermost module of multi-layer modules of the power cabinet (100), and one of the at least one first module (110) is a lowermost module of the multi-layer modules of the power cabinet (100),
**characterized in that** the first assembly portion (111) is mounted at a rear edge of the top surface of the first module (110);
the second assembly portion (121) is mounted at a rear edge of the top surface of the second module (120); and
each of the first assembly portion (111) and the second assembly portion (121) has a rear end extending to a back surface of the power cabinet (100).

2. The power cabinet (100) according to claim 1, wherein a projection of the first assembly portion (111) on a horizontal plane is coincident with a projection of the second assembly portion (121) on the horizontal plane.

3. The power cabinet (100) according to claim 1, wherein each of the first assembly portion (111) and the second assembly portion (121) is a recess, the recess being opened outwards at one of side walls of the recess.

4. The power cabinet (100) according to any one of claims 1 to 3, wherein:
each of the at least one first module (110) has a plurality of first positioning grooves (112), and each of the at least one second module (120) has a plurality of second positioning grooves (122) and a plurality of second positioning protrusions (123), wherein the plurality of first positioning grooves (112), the plurality of second positioning grooves (122), and the plurality of second positioning protrusions (123) are in one-to-one correspondence, and wherein the plurality of second positioning protrusions (123) is arranged at intervals on the top surface of each of the at least one second module (120); or
each of the at least one first module (110) has a plurality of first positioning grooves (112), and each of the at least one second module (120) has a plurality of second positioning grooves (122) and a plurality of second positioning protrusions (123), wherein the plurality of first positioning grooves (112), the plurality of second positioning grooves (122), and the plurality of second positioning protrusions (123) are in one-to-one correspondence, and wherein the plurality of second positioning protrusions (123) is arranged at intervals on the bottom surface of each of the at least one second module (120); or
each of the at least one first module (110) has a plurality of first positioning protrusions (113), and each of the at least one second module (120) has a plurality of second positioning grooves (122) and a plurality of second positioning protrusions (123), wherein the plurality of first positioning protrusions (113), the plurality of second positioning grooves (122), and the plurality of second positioning protrusions (123) are in one-to-one correspondence, and wherein the plurality of second positioning protrusions (123) is arranged at intervals on the top surface of each of the at least one second module (120).

5. The power cabinet (100) according to claim 4, wherein:
the plurality of second positioning protrusions (123) is arranged at intervals on respective edges of the top surface of each of the at least one second module (120); and/or
the plurality of second positioning protrusions (123) is arranged at intervals on respective edges of the bottom surface of each of the at least one second module (120); and/or
the plurality of first positioning protrusions (113) is arranged at intervals on respective edges of the bottom surface of each of the at least one first module (110).

6. The power cabinet according to any one of claims 1 to 3, wherein two ends of the assembly member (130) are connected to the first modules (110) or the second modules (120), wherein the assembly member (130) comprises a body segment (131) and a bent segment (132) connected to two ends of the body segment (131) and bent, the bent segment (132) being connected to the first assembly portion (111) or the second assembly portion (121).

7. The power cabinet (100) according to any one of claims 1 to 3, wherein one first module (110) and a plurality of second modules (120) are provided, the one first module (110) and the plurality of second modules (120) being stacked in the vertical direction,
wherein the one first module (110) is located above an uppermost second module (120) of the plurality of second modules (120).

8. The power cabinet (100) according to any one of claims 1 to 3, wherein two first modules (110) and at least one second module (120) are provided, the two first modules (110) and the at least one second module (120) being stacked in the vertical direction, wherein:
an uppermost first module (110) of the two first modules (110) is located above an uppermost second module (120) of the at least one second module (120); and
the at least one second module (120) is arranged between the two first modules (110).

## Patentansprüche

1. Leistungsschrank (100), umfassend:
mindestens ein erstes Modul (110), das mit einem ersten Montageabschnitt (111) versehen ist;
mindestens ein zweites Modul (120), das mit einem zweiten Montageabschnitt (121) versehen ist, wobei das mindestens eine erste Modul (110) und das mindestens eine zweite Modul (120) in einer vertikalen Richtung gestapelt sind; und
ein Montageelement (130),
wobei ein Ende des Montageelements (130) mit einem von dem ersten Montageabschnitt (111) und dem zweiten Montageabschnitt (121) verbunden ist und das andere Ende des Montageelements (130) dazu eingerichtet ist, mit dem jeweils anderen von dem ersten Montageabschnitt (111) und dem zweiten Montageabschnitts (121) verbunden zu werden oder mit einer Tragstruktur an einem Standort verbunden zu werden, an dem der Leistungsschrank (100) angeordnet ist; oder
wobei in einem Fall, in dem der Leistungsschrank (100) mindestens zwei erste Module umfasst, ein Ende des Montageelements (130) mit einem ersten Montageabschnitt (111) eines der mindestens zwei ersten Module verbunden ist und ein anderes Ende des Montageelements (130) mit einem ersten Montageabschnitt (111) eines anderen ersten Moduls verbunden ist; oder
wobei in einem Fall, in dem der Leistungsschrank (100) mindestens zwei zweite Module umfasst, ein Ende des Montageelements (130) mit einem zweiten Montageabschnitt (121) eines der mindestens zwei zweiten Module verbunden ist und ein anderes Ende des Montageelements (130) mit einem zweiten Montageabschnitt (121) eines anderen zweiten Moduls verbunden ist;
wobei
jedes des mindestens einen ersten Moduls (110) eine an einer Unterseite des ersten Moduls (110) ausgebildete erste Positionierungsnut (112) aufweist und jedes des mindestens einen zweiten Moduls (120) einen an einer Oberseite des zweiten Moduls (120) vorgesehenen zweiten Positionierungsvorsprung (123) und eine an einer Unterseite des zweiten Moduls (120) ausgebildete zweite Positionierungsnut (122) aufweist, wobei der zweite Positionierungsvorsprung (123) des zweiten Moduls (120) dazu eingerichtet ist, in einer ersten Positionierungsnut (112) eines ersten Moduls (110), das zu dem zweiten Modul (120) benachbart und oberhalb desselben angeordnet ist, positioniert und in Eingriff gebracht zu werden, oder der zweite Positionierungsvorsprung (123) des zweiten Moduls (120) dazu eingerichtet ist, in einer zweiten Positionierungsnut (122) eines anderen zweiten Moduls (120), das zu dem zweiten Modul (120) benachbart und oberhalb desselben angeordnet ist, positioniert und in Eingriff gebracht zu werden, wobei eines des mindestens einen ersten Moduls (110) ein oberstes Modul der mehrschichtig angeordneten Module des Leistungsschranks (100) ist; oder
jedes des mindestens einen ersten Moduls (110) eine an einer Oberseite des ersten Moduls (110) ausgebildete erste Positionierungsnut (112) aufweist und jedes des mindestens einen zweiten Moduls (120) eine an einer Oberseite des zweiten Moduls (120) ausgebildete zweite Positionierungsnut (122) und einen an einer Unterseite des zweiten Moduls (120) vorgesehenen zweiten Positionierungsvorsprung (123) aufweist, wobei der zweite Positionierungsvorsprung (123) des zweiten Moduls (120) dazu eingerichtet ist, in der ersten Positionierungsnut (112) eines ersten Moduls (110), das zu dem zweiten Modul (120) benachbart und unterhalb desselben angeordnet ist, positioniert und in Eingriff gebracht zu werden, oder der zweite Positionierungsvorsprung (123) des zweiten Moduls (120) dazu eingerichtet ist, in der zweiten Positionierungsnut (122) eines anderen zweiten Moduls (120), das zu dem zweiten Modul (120) benachbart und unterhalb desselben angeordnet ist, positioniert und in Eingriff gebracht zu werden, wobei eines des mindestens einen ersten Moduls (110) ein unterstes Modul der mehrschichtigen Module des Leistungsschranks (100) ist; oder
jedes des mindestens einen ersten Moduls (110) einen an einer Oberseite des ersten Moduls (110) vorgesehenen ersten Positionierungsvorsprung (113) aufweist und jedes des mindestens einen zweiten Moduls (120) einen an einer Oberseite des zweiten Moduls (120) vorgesehenen zweiten Positionierungsvorsprung (123) und eine an einer Unterseite des zweiten Moduls (120) ausgebildete zweite Positionierungsnut (122) aufweist, wobei die zweite Positionierungsnut (122) des zweiten Moduls (120) dazu eingerichtet ist, mit dem ersten Positionierungsvorsprung (113) eines ersten Moduls (110), das zu dem zweiten Modul (120) benachbart und unterhalb desselben angeordnet ist, positioniert und in Eingriff gebracht zu werden, oder die zweite Positionierungsnut (122) des zweiten Moduls (120) dazu eingerichtet ist, mit dem zweiten Positionierungsvorsprung (123) eines anderen zweiten Moduls (120), das zu dem zweiten Modul (120) benachbart und unterhalb desselben angeordnet ist, positioniert und in Eingriff gebracht zu werden, wobei eines des mindestens einen zweiten Moduls (120) ein oberstes Modul mehrschichtig angeordneter Module des Leistungsschranks (100) ist und eines des mindestens einen ersten Moduls (110) ein unterstes Modul der mehrschichtig angeordneten Module des Leistungsschranks (100) ist,
**dadurch gekennzeichnet, dass** der erste Montageabschnitt (111) an einer Hinterkante der Oberseite des ersten Moduls (110) angebracht ist;
der zweite Montageabschnitt (121) an einer Hinterkante der Oberseite des zweiten Moduls (120) angebracht ist; und
der erste Montageabschnitt (111) und der zweite Montageabschnitt (121) jeweils ein hinteres Ende aufweisen, das sich bis zu einer Rückseite des Leistungsschranks (100) erstreckt.

2. Leistungsschrank (100) nach Anspruch 1, wobei eine Projektion des ersten Montageabschnitts (111) auf eine horizontale Ebene mit einer Projektion des zweiten Montageabschnitts (121) auf die horizontale Ebene zusammenfällt.

3. Leistungsschrank (100) nach Anspruch 1, wobei der erste Montageabschnitt (111) und der zweite Montageabschnitt (121) jeweils als eine Aussparung ausgebildet sind, die an einer ihrer Seitenwände nach außen offen ist.

4. Leistungsschrank (100) nach einem der Ansprüche 1 bis 3, wobei:
jedes des mindestens einen ersten Moduls (110) mehrere erste Positionierungsnuten (112) aufweist und jedes des mindestens einen zweiten Moduls (120) mehrere zweite Positionierungsnuten (122) und mehrere zweite Positionierungsvorsprünge (123) aufweist, wobei die mehreren ersten Positionierungsnuten (112), die mehreren zweiten Positionierungsnuten (122) und die mehreren zweiten Positionierungsvorsprünge (123) in einer Eins-zu-Eins-Entsprechung stehen, und wobei die mehreren zweiten Positionierungsvorsprünge (123) in Abständen an der Oberseite jedes des mindestens einen zweiten Moduls (120) angeordnet sind; oder
jedes des mindestens einen ersten Moduls (110) mehrere erste Positionierungsnuten (112) aufweist und jedes des mindestens einen zweiten Moduls (120) mehrere zweite Positionierungsnuten (122) und mehrere zweite Positionierungsvorsprünge (123) aufweist, wobei die mehreren ersten Positionierungsnuten (112), die mehreren zweiten Positionierungsnuten (122) und die mehreren zweiten Positionierungsvorsprünge (123) in einer Eins-zu-Eins-Entsprechung stehen, und wobei die mehreren zweiten Positionierungsvorsprünge (123) in Abständen an der Unterseite jedes des mindestens einen zweiten Moduls (120) angeordnet sind; oder
jedes des mindestens einen ersten Moduls (110) mehrere erste Positionierungsvorsprünge (113) aufweist und jedes des mindestens einen zweiten Moduls (120) mehrere zweite Positionierungsnuten (122) und mehrere zweite Positionierungsvorsprünge (123) aufweist, wobei die mehreren ersten Positionierungsvorsprünge (113), die mehreren zweiten Positionierungsnuten (122) und die mehreren zweiten Positionierungsvorsprünge (123) in einer Eins-zu-Eins-Entsprechung stehen, und wobei die mehreren zweiten Positionierungsvorsprünge (123) in Abständen an der Oberseite jedes des mindestens einen zweiten Moduls (120) angeordnet sind.

5. Leistungsschrank (100) nach Anspruch 4, wobei:
die mehreren zweiten Positionierungsvorsprünge (123) in Abständen an jeweiligen Rändern der Oberseite jedes des mindestens einen zweiten Moduls (120) angeordnet sind; und/oder
die mehreren zweiten Positionierungsvorsprünge (123) in Abständen an jeweiligen Rändern der Unterseite jedes des mindestens einen zweiten Moduls (120) angeordnet sind; und/oder
die mehreren ersten Positionierungsvorsprünge (113) in Abständen an jeweiligen Rändern der Unterseite jedes des mindestens einen ersten Moduls (110) angeordnet sind.

6. Leistungsschrank nach einem der Ansprüche 1 bis 3, wobei zwei Enden des Montageelements (130) mit den ersten Modulen (110) oder den zweiten Modulen (120) verbunden sind, wobei das Montageelement (130) ein Körpersegment (131) und ein Biegungssegment(132) umfasst, das mit zwei Enden des Körpersegments (131) verbunden und gebogen ist, wobei das Biegungssegment (132) mit dem ersten Montageabschnitt (111) oder dem zweiten Montageabschnitt (121) verbunden ist.

7. Leistungsschrank (100) nach einem der Ansprüche 1 bis 3, wobei ein erstes Modul (110) und mehrere zweite Module (120) vorgesehen sind, wobei das eine erste Modul (110) und die mehreren zweiten Module (120) in der vertikalen Richtung gestapelt sind,
wobei das eine erste Modul (110) oberhalb eines obersten zweiten Moduls (120) der mehreren zweiten Module (120) angeordnet ist.

8. Leistungsschrank (100) nach einem der Ansprüche 1 bis 3, wobei zwei erste Module (110) und mindestens ein zweites Modul (120) vorgesehen sind, wobei die zwei ersten Module (110) und das mindestens eine zweite Modul (120) in der vertikalen Richtung gestapelt sind, wobei:
ein oberstes erstes Modul (110) der zwei ersten Module (110) oberhalb eines obersten zweiten Moduls (120) des mindestens einen zweiten Moduls (120) angeordnet ist; und
das mindestens eine zweite Modul (120) zwischen den zwei ersten Modulen (110) angeordnet ist.

## Revendications

1. Armoire de puissance (100), comprenant :
au moins un premier module (110) pourvu d'une première partie d'assemblage (111) ;
au moins un deuxième module (120) pourvu d'une deuxième partie d'assemblage (121), ledit au moins un premier module (110) et ledit au moins un deuxième module (120) étant empilés dans une direction verticale ; et
un élément d'assemblage (130),
dans laquelle une extrémité de l'élément d'assemblage (130) est reliée à l'une parmi la première partie d'assemblage (111) et la deuxième partie d'assemblage (121) ; et une autre extrémité de l'élément d'assemblage (130) est configurée pour être reliée à l'autre parmi la première partie d'assemblage (111) et la deuxième partie d'assemblage (121), ou reliée à une structure de support dans un site où l'armoire de puissance (100) est située ; ou
dans un cas où l'armoire de puissance (100) comprend au moins deux premiers modules, une extrémité de l'élément d'assemblage (130) est reliée à une première partie d'assemblage (111) de l'un desdits au moins deux premiers modules ; une autre extrémité de l'élément d'assemblage (130) est reliée à une première partie d'assemblage (111) d'un autre premier module ; ou
dans un cas où l'armoire de puissance (100) comprend au moins deux deuxièmes modules, une extrémité de l'élément d'assemblage (130) est reliée à une deuxième partie d'assemblage (121) de l'un desdits au moins deux deuxièmes modules ; une autre extrémité de l'élément d'assemblage (130) est reliée à une deuxième partie d'assemblage (121) d'un autre deuxième module ;
dans laquelle :
chacun dudit au moins un premier module (110) présente une première rainure de positionnement (112) formée sur une surface inférieure du premier module (110), et chacun dudit au moins un deuxième module (120) présente une deuxième saillie de positionnement (123) prévue sur une surface supérieure du deuxième module (120) et une deuxième rainure de positionnement (122) formée sur une surface inférieure du deuxième module (120), dans laquelle la deuxième saillie de positionnement (123) du deuxième module (120) est configurée pour être positionnée et engagée dans une première rainure de positionnement (112) d'un premier module (110) qui est adjacent à et au-dessus du deuxième module (120), ou la deuxième saillie de positionnement (123) du deuxième module (120) est configurée pour être positionnée et engagée dans une deuxième rainure de positionnement (122) d'un autre deuxième module (120) qui est adjacent à et au-dessus du deuxième module (120), dans laquelle l'un dudit au moins un premier module (110) est un module le plus haut de modules multicouches de l'armoire de puissance (100) ; ou
chacun dudit au moins un premier module (110) présente une première rainure de positionnement (112) formée sur une surface supérieure du premier module (110), et chacun dudit au moins un deuxième module (120) présente une deuxième rainure de positionnement (122) formée sur une surface supérieure du deuxième module (120) et une deuxième saillie de positionnement (123) prévue sur une surface inférieure du deuxième module (120), dans laquelle la deuxième saillie de positionnement (123) du deuxième module (120) est configurée pour être positionnée et engagée dans la première rainure de positionnement (112) d'un premier module (110) qui est adjacent à et en dessous du deuxième module (120), ou la deuxième saillie de positionnement (123) du deuxième module (120) est configurée pour être positionnée et engagée dans la deuxième rainure de positionnement (122) d'un autre deuxième module (120) qui est adjacent à et en dessous du deuxième module (120), dans laquelle l'un dudit au moins un premier module (110) est un module le plus bas de modules multicouches de l'armoire de puissance (100) ; ou
chacun dudit au moins un premier module (110) présente une première saillie de positionnement (113) prévue sur une surface supérieure du premier module (110), et chacun dudit au moins un deuxième module (120) présente une deuxième saillie de positionnement (123) prévue sur une surface supérieure du deuxième module (120) et une deuxième rainure de positionnement (122) formée sur une surface inférieure du deuxième module (120), dans laquelle la deuxième rainure de positionnement (122) du deuxième module (120) est configurée pour être positionnée et engagée avec la première saillie de positionnement (113) d'un premier module (110) qui est adjacent à et en dessous du deuxième module (120), ou la deuxième rainure de positionnement (122) du deuxième module (120) est configurée pour être positionnée et engagée avec la deuxième saillie de positionnement (123) d'un autre deuxième module (120) qui est adjacent à et en dessous du deuxième module (120), dans laquelle l'un dudit au moins un deuxième module (120) est un module le plus haut de modules multicouches de l'armoire de puissance (100), et l'un dudit au moins un premier module (110) est un module le plus bas des modules multicouches de l'armoire de puissance (100),
**caractérisée en ce que** la première partie d'assemblage (111) est montée au niveau d'un bord arrière de la surface supérieure du premier module (110) ;
la deuxième partie d'assemblage (121) est montée au niveau d'un bord arrière de la surface supérieure du deuxième module (120) ; et
chacune de la première partie d'assemblage (111) et de la deuxième partie d'assemblage (121) présente une extrémité arrière s'étendant vers une surface arrière de l'armoire de puissance (100).

2. Armoire de puissance (100) selon la revendication 1, dans laquelle une projection de la première partie d'assemblage (111) sur un plan horizontal coïncide avec une projection de la deuxième partie d'assemblage (121) sur le plan horizontal.

3. Armoire de puissance (100) selon la revendication 1, dans laquelle chacune de la première partie d'assemblage (111) et de la deuxième partie d'assemblage (121) est un évidement, l'évidement étant ouvert vers l'extérieur au niveau de l'une des parois latérales de l'évidement.

4. Armoire de puissance (100) selon l'une quelconque des revendications 1 à 3, dans laquelle :
chacun dudit au moins un premier module (110) présente une pluralité de premières rainures de positionnement (112), et chacun dudit au moins un deuxième module (120) présente une pluralité de deuxièmes rainures de positionnement (122) et une pluralité de deuxièmes saillies de positionnement (123), dans laquelle la pluralité de premières rainures de positionnement (112), la pluralité de deuxièmes rainures de positionnement (122) et la pluralité de deuxièmes saillies de positionnement (123) sont en correspondance biunivoque, et dans laquelle la pluralité de deuxièmes saillies de positionnement (123) est agencée à des intervalles sur la surface supérieure de chacun dudit au moins un deuxième module (120) ; ou
chacun dudit au moins un premier module (110) présente une pluralité de premières rainures de positionnement (112), et chacun dudit au moins un deuxième module (120) présente une pluralité de deuxièmes rainures de positionnement (122) et une pluralité de deuxièmes saillies de positionnement (123), dans laquelle la pluralité de premières rainures de positionnement (112), la pluralité de deuxièmes rainures de positionnement (122) et la pluralité de deuxièmes saillies de positionnement (123) sont en correspondance biunivoque, et dans laquelle la pluralité de deuxièmes saillies de positionnement (123) est agencée à des intervalles sur la surface inférieure de chacun dudit au moins un deuxième module (120) ; ou
chacun dudit au moins un premier module (110) présente une pluralité de premières saillies de positionnement (113), et chacun dudit au moins un deuxième module (120) présente une pluralité de deuxièmes rainures de positionnement (122) et une pluralité de deuxièmes saillies de positionnement (123), dans laquelle la pluralité de premières saillies de positionnement (113), la pluralité de deuxièmes rainures de positionnement (122) et la pluralité de deuxièmes saillies de positionnement (123) sont en correspondance biunivoque, et dans laquelle la pluralité de deuxièmes saillies de positionnement (123) est agencée à des intervalles sur la surface supérieure de chacun dudit au moins un deuxième module (120).

5. Armoire de puissance (100) selon la revendication 4, dans laquelle :
la pluralité de deuxièmes saillies de positionnement (123) est agencée à des intervalles sur des bords respectifs de la surface supérieure de chacun dudit au moins un deuxième module (120) ; et/ou
la pluralité de deuxièmes saillies de positionnement (123) est agencée à des intervalles sur des bords respectifs de la surface inférieure de chacun dudit au moins un deuxième module (120) ; et/ou
la pluralité de premières saillies de positionnement (113) est agencée à des intervalles sur des bords respectifs de la surface inférieure de chacun dudit au moins un premier module (110).

6. Armoire de puissance selon l'une quelconque des revendications 1 à 3, dans laquelle deux extrémités de l'élément d'assemblage (130) sont reliées aux premiers modules (110) ou aux deuxièmes modules (120), dans laquelle l'élément d'assemblage (130) comprend un segment de corps (131) et un segment plié (132) relié à deux extrémités du segment de corps (131) et plié, le segment plié (132) étant relié à la première partie d'assemblage (111) ou à la deuxième partie d'assemblage (121).

7. Armoire de puissance (100) selon l'une quelconque des revendications 1 à 3, dans laquelle un premier module (110) et une pluralité de deuxièmes modules (120) sont prévus, le un premier module (110) et la pluralité de deuxièmes modules (120) étant empilés dans la direction verticale,
dans laquelle le un premier module (110) est situé au-dessus d'un deuxième module le plus haut (120) de la pluralité de deuxièmes modules (120).

8. Armoire de puissance (100) selon l'une quelconque des revendications 1 à 3, dans laquelle deux premiers modules (110) et au moins un deuxième module (120) sont prévus, les deux premiers modules (110) et ledit au moins un deuxième module (120) étant empilés dans la direction verticale, dans laquelle :
un premier module le plus haut (110) des deux premiers modules (110) est situé au-dessus d'un deuxième module le plus haut (120) dudit au moins un deuxième module (120) ; et
ledit au moins un deuxième module (120) est agencé entre les deux premiers modules (110).
